(19) Europäisches Patentamt
European Patent Office
Office européen des brevets

(11) EP 2 479 228 A1

(12) # EUROPEAN PATENT APPLICATION
published in accordance with Art. 153(4) EPC

(43) Date of publication:
**25.07.2012 Bulletin 2012/30**

(21) Application number: **10816858.4**

(22) Date of filing: **09.09.2010**

(51) Int Cl.:
***C09J 7/00*** *(2006.01)* ***C09J 11/06*** *(2006.01)*
***C09J 163/00*** *(2006.01)* ***C09J 201/10*** *(2006.01)*
***H01L 21/60*** *(2006.01)* ***H05K 3/34*** *(2006.01)*

(86) International application number:
**PCT/JP2010/005510**

(87) International publication number:
**WO 2011/033743 (24.03.2011 Gazette 2011/12)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **16.09.2009 JP 2009214528**

(71) Applicant: **Sumitomo Bakelite Co., Ltd.**
**Shinagawa-ku**
**Tokyo 140-0002 (JP)**

(72) Inventors:
- **MAEJIMA, Kenzou**
  **Tokyo 140-0002 (JP)**
- **KATSURAYAMA, Satoru**
  **Tokyo 140-0002 (JP)**

(74) Representative: **Vossius, Corinna et al**
**Dr. Volker Vossius**
**Patent- und Rechtsanwaltskanzlei**
**Geibelstrasse 6**
**81679 München (DE)**

(54) **ADHESIVE FILM, MULTILAYER CIRCUIT BOARD, ELECTRONIC COMPONENT, AND SEMICONDUCTOR DEVICE**

(57) Disclosed is an adhesive film in which the adhesive film contains a thermosetting resin (A), a curing agent (B), a compound having flux activity (C) and a film forming resin (D), the minimum melt viscosity of the adhesive film is 0.01 to 10,000 Pa·s, and the adhesive film satisfies the following formula (1) when the exothermic peak temperature of the adhesive film is defined as (a) and the 5% weight loss temperature by thermogravimetry of the adhesive film is defined as (b),

$$(b)-(a) \geq 100 \text{ degrees centigrade} \quad (1).$$

FIG.1

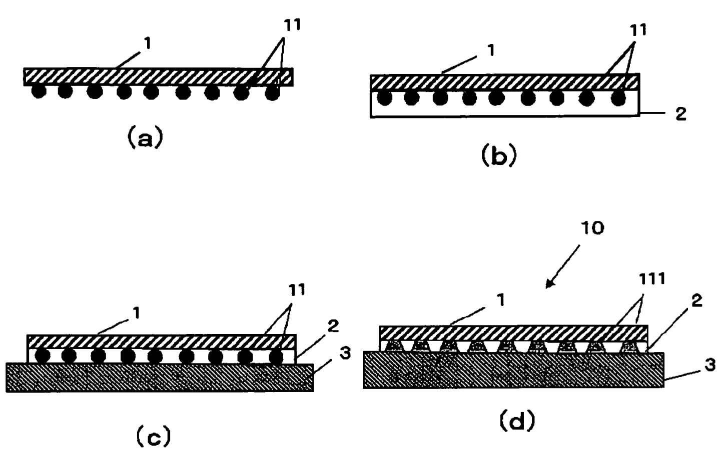


EP 2 479 228 A1

## Description

TECHNICAL FIELD

The present invention relates to an adhesive film, a multilayer circuit board, an electronic component and a semiconductor device.

BACKGROUND ART

With the recent requirements of higher functionality, lightness, thinning, miniaturization and compactization in electronic equipments, high-density integration and high-density mounting of electronic components such as semiconductor packages and the like are in progress, while reduction in size and high pin counts of these electronic components are in progress. In order to achieve electrical connection of these electronic components, solder bonding is used.

As solder bonding, there may be, for example, a conductive bonding portion between semiconductor chips, a conductive bonding portion between a semiconductor chip and a circuit board such as a package with a flip chip mounting, a conductive bonding portion between circuit boards, and the like. In order to secure the electrical connection strength and mechanical connection strength, an encapsulating resin which is generally called an underfill material is injected into this solder bonding portion (underfill encapsulation).

When gaps generated in this solder bonding portion are reinforced with a liquid encapsulating resin (an underfill material), the liquid encapsulating resin (the underfill material) is supplied after solder bonding and the resultant is cured, whereby the solder bonding portion is reinforced. However, with thinning and reduction in size of the electronic components, the solder bonding portion has narrow pitches and narrow gaps, so that although the liquid encapsulating resin (the underfill material) is supplied after solder bonding, there is a problem such that the liquid encapsulating resin (the underfill material) is not spread between gaps and not fully filled therebetween either.

In response to such a problem, there has been known a method involving carrying out electrical connection and attachment between terminals at one time through an anisotropic conductive film. For example, there have been disclosed a method in which an adhesive film containing solder particles is interposed between members and the resultant is subjected to thermo-compression bonding, whereby solder particles are interposed between terminals of both members and a resin component is filled in the other portion, and a method of achieving electrical connection by the contact with metal particles (for example, see Patent Documents 1 and 2).

RELATED DOCUMENT

PATENT DOCUMENT

Patent Document 1: Japanese Unexamined Patent Application Publication No. S61-276873
Patent Document 2: Japanese Unexamined Patent Application Publication No. H09-31419

DISCLOSURE OF THE INVENTION

However, in these methods, it was difficult to secure insulation properties between adjacent terminals because of the presence of conductive particles between adjacent terminals, and difficult to secure the reliability of the electronic component and the semiconductor device because of the presence of bubbles between adjacent terminals.

An object of the present invention is to provide an adhesive film which can achieve both excellent electrical connectivity and insulation reliability while connecting between terminals of opposing members and encapsulating gaps between members, and a multilayer circuit board, an electronic component and a semiconductor device using the adhesive film.

Such an object is achieved by the matters described in the following [1] to [14].

[1] An adhesive film electrically connecting a first terminal of a support and a second terminal of an adherend using solders, and attaching the support to the adherend, wherein the adhesive film contains a thermosetting resin (A), a curing agent (B), a compound having flux activity (C) and a film forming resin (D), the minimum melt viscosity of the adhesive film is from 0.01 to 10,000 Pa·s, and the adhesive film satisfies the following formula (1) when the exothermic peak temperature (degrees centigrade) of the adhesive film is defined as (a) and the 5% weight loss temperature by thermogravimetry (degrees centigrade) of the adhesive film is defined as (b),

$$(b)-(a) \geq 100 \text{ degrees centigrade} \qquad (1).$$

[2] The adhesive film according to [1], wherein the mixing ratio ((A)/(C)) of the thermosetting resin (A) to the compound having flux activity (C) is from 0.5 to 20.

[3] The adhesive film according to [1] or [2], wherein the content of the thermosetting resin (A) is from 5 to 80% by weight, based on the adhesive film.

[4] The adhesive film according to any one of [1] to [3], wherein the thermosetting resin (A) is an epoxy resin.

[5] The adhesive film according to any one of [1] to [4], wherein the compound having flux activity (C) is a flux activating compound having a carboxyl group and/or a phenolic hydroxyl group.

[6] The adhesive film according to any one of [1] to [4], wherein the compound having flux activity (C) is a flux activating compound containing, in one molecule thereof, two phenolic hydroxyl groups and at least one carboxyl group which is directly bonded to an aromatic ring.

[7] The adhesive film according to any one of [1] to [6], wherein the compound having flux activity (C) contains a compound represented by the following general formula (2),

$$HOOC\text{-}(CH_2)_n\text{-}COOH \qquad (2)$$

wherein, in the general formula (2), n is an integer of 1 to 20.

[8] The adhesive film according to any one of [1] to [6], wherein the compound having flux activity (C) contains a compound represented by the following general formula (3) and/or (4),

[Chemical Formula 1]

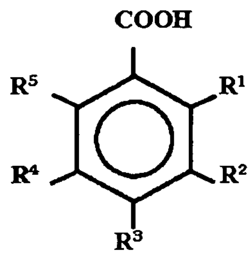

(3)

wherein, in the general formula (3), $R^1$ to $R^5$ are each independently a monovalent organic group, and at least one of $R^1$ to $R^5$ is a hydroxyl group,

[Chemical Formula 2]

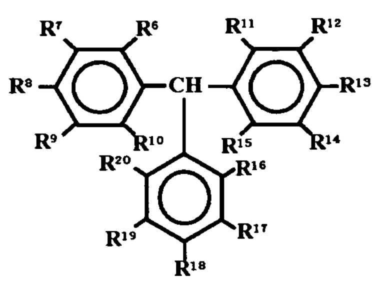

(4)

wherein, in the general formula (4), $R^6$ to $R^{20}$ are each independently a monovalent organic group, and at least one of $R^6$ to $R^{20}$ is a hydroxyl group or a carboxyl group.

[9] The adhesive film according to any one of [1] to [8], wherein the adhesive film further contains a filler (G).

[10] The adhesive film according to [9], wherein the content of the filler (G) is equal to or more than 0.1% by weight and equal to or less than 80% by weight, based on the adhesive film.

[11] The adhesive film according to any one of [1] to [10], wherein the adhesive film further contains a silane coupling agent (F) in an amount of equal to or more than 0.01% by weight and equal to or less than 5% by weight, based on

the adhesive film.

[12] A multilayer circuit board, having a cured product of the adhesive film according to any one of [1] to [11].

[13] An electronic component, having a cured product of the adhesive film according to any one of [1] to [11].

[14] A semiconductor device, having a cured product of the adhesive film according to any one of [1] to [11].

## EFFECT OF THE INVENTION

According to the present invention, there are provided an adhesive film which can achieve both excellent electrical connectivity and insulation reliability while connecting between terminals of opposing members and encapsulating gaps between members, and a multilayer circuit board, an electronic component and a semiconductor device using the adhesive film.

## BRIEF DESCRIPTION OF THE DRAWINGS

Fig. 1 is a process cross-sectional view illustrating one example of the method for producing a semiconductor device using the adhesive film of the present invention.

## DESCRIPTION OF EMBODIMENTS

Hereinafter, the adhesive film, the multilayer circuit board, the electronic component and the semiconductor device of the present invention will be described.

The adhesive film of the present invention is an adhesive film electrically connecting a first terminal of a support and a second terminal of an adherend using solders, and attaching the support to the adherend, in which the adhesive film contains a thermosetting resin (A), a curing agent (B), a compound having flux activity (C) and a film forming resin (D), the minimum melt viscosity of the adhesive film is from 0.01 to 10,000 Pa·s, and the adhesive film satisfies the following formula (1) when the exothermic peak temperature (degrees centigrade) of the adhesive film is defined as (a) and the 5% weight loss temperature by thermogravimetry (degrees centigrade) of the adhesive film is defined as (b),

$$(b)-(a) \geq 100 \text{ degrees centigrade} \qquad (1)$$

Furthermore, the multilayer circuit board, the electronic component and the semiconductor device of the present invention are obtained by electrically connecting a support having a first terminal and an adherend having a second terminal and attaching the support to the adherend by the use of the aforementioned adhesive film.

Hereinafter, the adhesive film, the multilayer circuit board, the electronic component and the semiconductor device of the present invention will be described in detail.

### Adhesive Film

The minimum melt viscosity of the adhesive film of the present invention is from 0.01 to 10,000 Pa·s. When the minimum melt viscosity of the adhesive film is from 0.01 to 10,000 Pa·s, excellent connection reliability can be secured at the time that the adhesive film is interposed between the first terminal of the support and the second terminal of the adherend facing to each other, the adhesive film is heated and melted, and the support and the adherend are electrically connected to each other and attached.

When the minimum melt viscosity is equal to or more than 0.01 Pa·s, it is possible to prevent the melted adhesive film from being crept into the support and the adherend, and from contaminating the support and the adherend. On the other hand, when the minimum melt viscosity is equal to or less than 10,000 Pa·s, it is possible to prevent the melted adhesive film from being caught between opposing terminals and from causing conduction defects.

The minimum melt viscosity is preferably equal to or more than 0.02 Pa·s and particularly preferably equal to or more than 0.05 Pa·s. Thus, it is possible to more effectively prevent the melted adhesive film from being crept into the support and the adherend, and from contaminating the support and the adherend. On the other hand, the minimum melt viscosity is preferably equal to or less than 8, 000 Pa·s and particularly preferably equal to or less than 7,000 Pa·s. Thus, it is possible to more effectively prevent the melted adhesive film from being caught between opposing terminals and from causing conduction defects.

Herein, the minimum melt viscosity of the adhesive film may be measured under the conditions of a parallel plate of 20 mmφ, a gap of 0.05 mm, a frequency of 0.1 Hz and a temperature increase rate of 10 degrees centigrade/min using a viscoelasticity measuring instrument (RheoStress RS150, commercially available from HAKKE Corp.).

A method of having the melt viscosity of the adhesive film in the above range is not particularly limited, but it may be carried out by properly selecting the softening points and the mixing amounts of the thermosetting resin (A), the curing agent (B) and the film forming resin (D) constituting the adhesive film.

Meanwhile, the adhesive film satisfies the following formula (1) when the exothermic peak temperature of the adhesive film is defined as (a) and the 5% weight loss temperature by thermogravimetry of the adhesive film is defined as (b). Thus, generation of voids can be inhibited at the time that the adhesive film is interposed between the first terminal of the support body and the second terminal of the adherend facing to each other, the adhesive film is heated and melted, and the support body and the adherend are electrically connected to each other and attached. Thus, it is possible to improve the reliability of the multilayer circuit board, the electronic component and the semiconductor device that are manufactured.

$$(b)-(a) \geq 100 \text{ degrees centigrade} \quad (1)$$

In the present invention, the exothermic peak temperature (a) refers to one of physical properties exhibiting curing behavior of an adhesive film. When the exothermic peak temperature (a) is low, a curing reaction easily takes place, so that the contact between the electrodes is inhibited or life (storage stability) is reduced in some cases. On the contrary, when the exothermic peak temperature (a) is excessively high, there is a problem of an increase in the heating temperature for curing.

On the other hand, in the present invention, the 5% weight loss temperature by thermogravimetry (b) refers to one of physical properties exhibiting heat resistance of an adhesive film. As the 5% weight loss temperature by thermogravimetry (b) is increased, heat resistance will be preferably increased. Furthermore, the 5% weight loss temperature by thermogravimetry (b) being low means that there are lots of decomposition products and volatile substances due to heating. That is, as the 5% weight loss temperature by thermogravimetry (b) is lowered, causes of voids (bubbles) will be increased in the adhesive film after curing and voids will be easily caused.

When the difference between the 5% weight loss temperature by thermogravimetry (b) and the exothermic peak temperature (a) of the adhesive film is equal to or more than 100 degrees centigrade, the support and the adherend are electrically connected by heating and melting the adhesive film so as not to proceed with the curing reaction of the adhesive film that much, and thereafter the support and the adherend are attached to each other by heating and curing the adhesive film. Furthermore, when it is equal to or more than 100 degrees centigrade, margin in a process is secured, and occurrence of voids is much reduced.

Accordingly, as the difference between the 5% weight loss temperature by thermogravimetry (b) and the exothermic peak temperature (a) of the adhesive film is increased, outgases will be hardly generated by heating the adhesive film, so that generation of bubbles after electrical connection and attachment can be prevented. Furthermore, even when outgases are generated, the temperature at which outgases begin to be generated is higher than the temperature at which the curing reaction of the adhesive film begins, and outgases are generated after curing of the adhesive film proceeds, so that outgases hardly move in the three-dimensional cross-linked adhesive film. Thus, generation of voids after electrical connection and attachment can be inhibited.

The difference between the 5% weight loss temperature by thermogravimetry (b) and the exothermic peak temperature (a) of the adhesive film is preferably equal to or more than 120 degrees centigrade and particularly preferably equal to or more than 150 degrees centigrade. Thus, generation of outgases in the adhesive film can be more effectively inhibited. Furthermore, even if the outgases are temporarily generated, outgases hardly move in the adhesive film, so that generation of voids after electrical connection and attachment can be more effectively inhibited.

Herein, the exothermic peak temperature (a) of the adhesive film may be measured under the condition of a temperature increase rate of 10 degrees centigrade/min using a differential scanning calorimeter (DSC-6200, commercially available from Seiko Instruments Inc.).

The 5% weight loss temperature by thermogravimetry (b) of the adhesive film may be measured under the condition of a temperature increase rate of 10 degrees centigrade/min using a thermo-gravimetric/differential thermal analyzer (TG/DTA6200, commercially available from Seiko Instruments Inc.).

A method of having the difference between the 5% weight loss temperature by thermogravimetry (b) and the exothermic peak temperature (a) of the adhesive film in the above range is not particularly limited, but it may be carried out by properly selecting the softening points and the contents of the thermosetting resin (A), the curing agent (B) and the compound having flux activity (C), and further the content of the low molecular weight component.

The adhesive film of the present invention contains the thermosetting resin (A), the curing agent (B), the compound having flux activity (C) and the film forming resin (D). Hereinafter, respective components will be described.

(A) Thermosetting Resin

The thermosetting resin (A) is not particularly limited, and examples include an epoxy resin, a phenoxy resin, a silicone resin, an oxetane resin, a phenol resin, a (meth)acrylate resin, a polyester resin (an unsaturated polyester resin), a diallyl phthalate resin, a maleimide resin, a polyimide resin (a polyimide precursor resin), a bismaleimide-triazine resin and the like. In particular, preferably used are thermosetting resins containing at least one kind selected from the group consisting of an epoxy resin, a (meth)acrylate resin, a phenoxy resin, a polyester resin, a polyimide resin, a silicone resin, a maleimide resin and a bismaleimide-triazine resin. Among these, preferably used is an epoxy resin from the viewpoints of excellent curability, storage stability, heat resistance of the cured product, moisture resistance and chemical resistance. Furthermore, these thermosetting resins may be used singly or may be used in combination of two or more kinds.

The content of the thermosetting resin (A) is not particularly limited, but it is preferably from 5 to 80% by weight, more preferably from 9 to 75% by weight and particularly preferably from 10 to 55% by weight, based on the adhesive film. When the content of the thermosetting resin (A) is equal to or more than the above lower limit, heat resistance of the adhesive film after curing is improved, so that the reliability of the multilayer circuit board, the electronic component and the semiconductor device can be improved. On the other hand, when it is equal to or less than the above upper limit, an excessive increase in the elastic modulus of the adhesive film after curing is inhibited, so that adhesion between the support and the adherend can be improved.

The aforementioned epoxy resin is not particularly limited and examples include a bisphenol A type epoxy resin, a bisphenol F type epoxy resin, a phenol novolac type epoxy resin, a cresol novolac type epoxy resin, a glycidyl amine type epoxy resin, a glycidyl ester type epoxy resin, a trifunctional epoxy resin, a tetrafunctional epoxy resin and the like.

For the aforementioned epoxy resin, the viscosity at 25 degrees centigrade is preferably from 500 to 50,000 mPa·s and more preferably from 800 to 40,000 mPa·s. When the viscosity at 25 degrees centigrade is equal to or more than the above lower limit, flexibility and bendability of the adhesive film can be secured. On the other hand, when the viscosity at 25 degrees centigrade is equal to or less than the above upper limit, it is possible to prevent deterioration of handling properties by strong tack properties of the adhesive film.

The content of the aforementioned epoxy resin is not particularly limited, but it is preferably from 5 to 80% by weight and particularly preferably from 9 to 75% by weight, based on the adhesive film. When it is equal to or more than the above lower limit, flexibility and bendability of the adhesive film can be more effectively exhibited. On the other hand, when it is equal to or less than the above upper limit, it is possible to more effectively prevent deterioration of handling properties by strong tack properties of the adhesive film.

Among the aforementioned epoxy resins, preferably used are a liquid bisphenol A type epoxy resin and a liquid bisphenol F type epoxy resin from the viewpoint that both control of the melt viscosity of the adhesive film in the range of 0.01 to 10,000 Pa·s and workability (tack properties and bendability) of the adhesive film may be combined.

(B) Curing Agent

The curing agent (B) is not particularly limited, and may be properly selected depending on the kind of the thermosetting resin (A) in use. Examples of the curing agent (B) include phenols, amines, thiols, acid anhydrides, isocyanates and the like. These curing agents may be used singly or may be used in combination of two or more kinds.

When an epoxy resin is used as the thermosetting resin (A), phenols are preferably used as the curing agent (B). With the use of phenols as the curing agent (B), heat resistance of the adhesive film after curing is increased and further the moisture absorption ratio is lowered, so that the reliability of the multilayer circuit board, the electronic component and the semiconductor device can be improved.

The aforementioned phenols are not particularly limited, and examples include a phenol novolac resin, a cresol novolac resin, a bisphenol A type novolac resin, a bisphenol F type novolac resin, a bisphenol AF type novolac resin and the like. However, preferably used are a phenol novolac resin and a cresol novolac resin in which the glass transition temperature of the cured product of the adhesive film may be effectively increased and components generating outgases may be reduced.

The total content of from mononuclear components to trinuclear components in the aforementioned phenol novolac resin or cresol novolac resin is preferably from 30 to 70%. Thus, it is possible to increase the glass transition temperature of the cured product of the adhesive film, to decrease the amount of the phenol type novolac resin generating outgases, and to improve ionic migration resistance. Furthermore, suitable flexibility may be imparted to the adhesive film, so that brittleness of the adhesive film can be improved. Furthermore, suitable tack properties may be imparted to the adhesive film, so that an adhesive film excellent in workability can be obtained.

When the total content of from mononuclear components to trinuclear components is smaller than 30% (the total content of tetra- or higher nuclear components is equal to or more than 70%), the reactivity with the aforementioned

epoxy resin is lowered and the unreacted phenol type novolac resin in the cured product of the adhesive film remains, so that there are problems such that migration resistance is lowered, the adhesive film becomes brittle, and workability is lowered. On the other hand, when the total content of from mononuclear components to trinuclear components is greater than 70% (the total content of tetra- or higher nuclear components is equal to or less than 30%), there are problems such that the amount of outgases is increased at the time of curing of the adhesive film, thus causing contamination on the surface of the support or the adherend, or deterioration of migration resistance, and tack properties of the adhesive film are increased, thus lowering workability of the adhesive film.

The total content of binuclear components and trinuclear components in the aforementioned phenol novolac resin or cresol novolac resin is not particularly limited, but it is preferably from 30 to 70%. When it is equal to or more than the above lower limit, it is possible to more effectively prevent an increase in the amount of outgases at the time of curing of the adhesive film which causes contamination on the surface of the support body or the adherend. On the other hand, when it is equal to or less than the above upper limit, it is possible to more effectively secure flexibility and bendability of the adhesive film.

The content of mononuclear components in the aforementioned phenol novolac resin or cresol novolac resin is not particularly limited, but it is preferably equal to or less than 1% and particularly preferably equal to or less than 0.8%, based on the adhesive film. When the content of the mononuclear components is in the above range, the amount of outgases at the time of curing of the adhesive film can be reduced, contamination of the support or the adherend can be suppressed, and further migration resistance can be improved.

The weight average molecular weight of the aforementioned phenol novolac resin or cresol novolac resin is not particularly limited, but it is preferably from 300 to 3,000 and particularly preferably from 400 to 2,800. When it is equal to or more than the above lower limit, it is possible to more effectively prevent an increase in the amount of outgases at the time of curing of the adhesive film which causes contamination on the surface of the support or the adherend. On the other hand, when it is equal to or less than the above upper limit, it is possible to more effectively secure flexibility and bendability of the adhesive film.

(C) Compound having flux activity

The adhesive film of the present invention contains a compound having flux activity (C). Thus, an oxide layer formed on the solder surface of at least one of the first terminal of the support and the second terminal of the adherend can be removed, and depending on the situation, an oxide layer formed on the surface of the first terminal of the support or the second terminal of the adherend can be removed, and the first terminal and the second terminal can be surely solder-bonded. Accordingly, it is possible to obtain a multilayer circuit board, an electronic component and a semiconductor device having high connection reliability.

The compound having flux activity (C) is not particularly limited as long as a flux activating compound acts to remove the oxide layer on the solder surface, and preferably used is a compound having any of a carboxyl group or a phenolic hydroxyl group, or both of a carboxyl group and a phenolic hydroxyl group.

The mixing amount of the compound having flux activity (C) is from 1 to 30% by weight and particularly preferably from 3 to 20% by weight. When the mixing amount of the compound having flux activity (C) is in the above range, the flux activity can be improved, and at the same time the unreacted thermosetting resin (A) and compound having flux activity (C) remained at the time of curing of the adhesive film for generating outgases during thermal curing of the adhesive film can be inhibited, and migration resistance can be improved.

Meanwhile, the compound having flux activity (C) is present in the compound acting as a curing agent of the epoxy resin (hereinafter such a compound is also referred to as the curing agent having flux activity). For example, an aliphatic dicarboxylic acid, an aromatic dicarboxylic acid and the like acting as a curing agent of the epoxy resin have a flux activity as well. In the present invention, such a curing agent having flux activity acting as a flux and acting as a curing agent of the epoxy resin as well may be suitably used.

Incidentally, the compound having flux activity (C) having a carboxyl group refers to a compound having one or more of carboxyl groups in a molecule. Such compounds may be in the form of a liquid or a solid at a room temperature. Meanwhile, the compound having flux activity (C) having a phenolic hydroxyl group refers to a compound having one or more of phenolic hydroxyl groups in a molecule. Such compounds may be in the form of a liquid or a solid at a room temperature. The compound having flux activity (C) having a carboxyl group and a phenolic hydroxyl group refers to a compound having one or more of carboxyl groups and one or more of phenolic hydroxyl groups in a molecule. Such compounds may be in the form of a liquid or a solid at a room temperature.

Among these, examples of the compound having flux activity (C) having a carboxyl group include an aliphatic acid anhydride, an alicyclic acid anhydride, an aromatic acid anhydride, an aliphatic carboxylic acid, an aromatic carboxylic acid and the like.

Examples of the aliphatic acid anhydride of the compound having flux activity (C) having a carboxyl group include a succinic acid anhydride, a polyadipic acid anhydride, a polyazelaic acid anhydride, a polysebacic acid anhydride

and the like.

Examples of the alicyclic acid anhydride of the compound having flux activity (C) having a carboxyl group include a methyl tetrahydrophthalic acid anhydride, a methyl hexahydrophthalic acid anhydride, a methyl himic acid anhydride, a hexahydrophthalic acid anhydride, a tetrahydrophthalic acid anhydride, a trialkyl tetrahydrophthalic acid anhydride, a methyl cyclohexene dicarboxylic acid anhydride and the like.

Examples of the aromatic acid anhydride of the compound having flux activity (C) having a carboxyl group include a phthalic acid anhydride, a trimellitic acid anhydride, a pyromellitic acid anhydride, a benzophenone tetracarboxylic acid anhydride, ethylene glycol bistrimellitate, glycerol tristrimellitate and the like.

Examples of the aliphatic carboxylic acid of the compound having flux activity (C) having a carboxyl group include a compound represented by the following general formula (2), formic acid, acetic acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, succinic acid and the like,

$$HOOC\text{-}(CH_2)_n\text{-}COOH \qquad (2)$$

wherein, in the general formula (2), n represents an integer of equal to or more than 1 and equal to or less than 20.

Among the aforementioned aliphatic carboxylic acids, preferably used is a compound represented by the general formula (2) from the viewpoint of an excellent balance among the activity degree of the compound having flux activity (C), the amount of outgases generated at the time of curing of the adhesive film, the elastic modulus and the glass transition temperature of the adhesive film after curing, and the like. Among the compounds represented by the general formula (2), particularly preferably used is a compound in which n is 3 to 10 from the viewpoints that an increase in the elastic modulus in the adhesive film after curing may be suppressed and at the same time adhesion between the support and the adherend may be improved.

Among the compounds represented by the general formula (2), examples of the compound in which n is 3 to 10 include glutaric acid (n=3: $HOOC\text{-}(CH_2)_3\text{-}COOH$), adipic acid (n=4: $HOOC\text{-}(CH_2)_4\text{-}COOH$), pimelic acid (n=5: $HOOC\text{-}(CH_2)_5\text{-}COOH$), sebacic acid (n=8: $HOOC\text{-}(CH_2)_8\text{-}COOH$), $HOOC\text{-}(CH_2)_{10}\text{-}COOH$ (n=10) and the like.

Examples of the aromatic carboxylic acid of the compound having flux activity (C) having a carboxyl group include compounds having flux activity (C) represented by the following general formula (3) or (4),

[Chemical Formula 3]

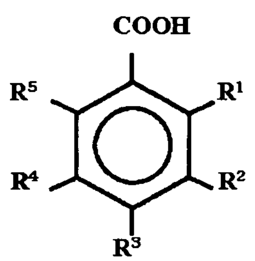

(3)

wherein, in the general formula (3), $R^1$ to $R^5$ are each independently a monovalent organic group, and at least one of $R^1$ to $R^5$ is a hydroxyl group,

[Chemical Formula 4]

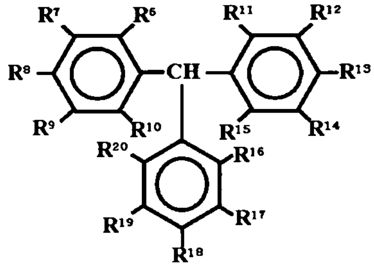

(4)

wherein, in the general formula (4), $R^6$ to $R^{20}$ are each independently a monovalent organic group, and at least one of $R^6$ to $R^{20}$ is a hydroxyl group or a carboxyl group.

Examples of the aforementioned aromatic carboxylic acid include benzoic acid, phthalic acid, isophthalic acid, terephthalic acid, hemimellitic acid, trimellitic acid, trimesic acid, mellophanic acid, prehnitic acid, pyromellitic acid, mellitic acid, triilic acid, xylic acid, hemelitic acid, mesitylenic acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid, gallic acid (3,4,5-trihydroxybenzoic acid), naphthoic acid derivatives such as 1,4-dihydroxy-2-naphthoic acid and 3,5-dihydroxy-2-naphthoic acid, phenolphthalin, diphenolic acid, and the like.

Among the compounds having flux activity (C) represented by the general formula (3) or (4), preferably used is a compound containing, in one molecule thereof, two or more phenolic hydroxyl groups which may be added to the epoxy resin, and at least one carboxyl group which is directly bonded to an aromatic ring capable of exhibiting a flux activity (reduction) from the viewpoint of improvement in formation of a three-dimensional cross-linked network of the epoxy resin after curing. Examples of such a curing agent having flux activity include benzoic acid derivatives such as 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid, gallic acid (3,4,5-trihydroxybenzoic acid) and the like; naphthoic acid derivatives such as 1,4-dihydroxy-2-naphthoic acid, 3,5-dihydroxy-2-naphthoic acid, 3,7-dihydroxy-2-naphthoic acid and the like; phenolphthalin; diphenolic acid, and the like. These may be used singly or may be used in combination of two or more kinds. Among these, preferably used are 2,3-dihydroxybenzoic acid, gentisic acid and phenolphthalin, which are excellent in the effect of removing the oxide layer formed on the solder surface and excellent in the reactivity with the epoxy resin.

Examples of the compound having flux activity (C) having a phenolic hydroxyl group include phenols. Concrete examples include monomers having a phenolic hydroxyl group such as phenol, o-cresol, 2,6-xylenol, p-cresol, m-cresol, o-ethylphenol, 2,4-xylenol, 2,5-xylenol, m-ethylphenol, 2,3-xylenol, meditol, 3,5-xylenol, p-tert-butylphenol, catechol, p-tert-amylphenol, resorcinol, p-octylphenol, p-phenylphenol, bisphenol A, bisphenol F, bisphenol AF, biphenol, diallyl bisphenol F, diallyl bisphenol A, trisphenol, tetrakisphenol and the like.

Meanwhile, the mixing amount of the curing agent having flux activity in the adhesive film is preferably from 1 to 30% by weight and particularly preferably from 3 to 20% by weight. When the mixing amount of the curing agent having flux activity in the adhesive film is in the above range, the flux activity of the adhesive film is improved, and at the same time the epoxy resin and the unreacted curing agent having flux activity are prevented from being remained in the adhesive film. Incidentally, when the unreacted curing agent having flux activity remains, migration takes place.

The mixing ratio ((A)/(C)) of the thermosetting resin (A) to the compound having flux activity (C) is not particularly limited, but it is preferably from 0.5 to 20, particularly preferably from 1 to 18 and further preferably from 2 to 15. When ((A)/(C)) is equal to or more than the above lower limit, the amount of the compound having flux activity (C) generating outgases is reduced at the time of curing of the adhesive film, so that voids in the adhesive film can be reduced. On the other hand, when ((A)/(C)) is equal to or less than the above upper limit, the oxide layer formed on the terminal surface of the adherend or the support, or on the solder surface can be effectively removed.

(D) Film Forming Resin

The adhesive film of the present invention contains a film forming resin (D). Thus, film-forming properties of the adhesive film are improved and make it easy to form a film. Furthermore, mechanical properties of the adhesive film are also excellent.

The film forming resin (D) is not particularly limited, and examples include a (meth)acrylic resin, a phenoxy resin, a polyester resin, a polyurethane resin, a polyimide resin, a siloxane-modified polyimide resin, polybutadiene, polypropylene, a styrene-butadiene-styrene copolymer, a styrene-ethylene-butylene-styrene copolymer, a polyacetal resin, a polyvinyl butyral resin, a polyvinyl acetal resin, a butyl rubber, a chloroprene rubber, a polyamide resin, an acrylonitrile-butadiene copolymer, an acrylonitrile-butadiene-acrylic acid copolymer, an acrylonitrile-butadiene-styrene copolymer, polyvinyl acetate, nylon and the like. These may be used singly or may be used in combination of two or more kinds. Among these, preferably used is at least one kind selected from the group consisting of a (meth)acrylic resin, a phenoxy resin and a polyimide resin.

The weight average molecular weight of the film forming resin (D) is not particularly limited, but it is preferably equal to or more than 10,000, more preferably from 20,000 to 1,000,000 and further preferably from 30,000 to 900,000. When the weight average molecular weight is in the above range, film-forming properties of the adhesive film can be further improved.

The content of the film forming resin (D) is not particularly limited, but it is preferably from 5 to 70% by weight, more preferably from 10 to 60% by weight and particularly preferably from 15 to 55% by weight, based on the adhesive film. When the content is within the above range, the fluidity of the adhesive film is suppressed and handling of the adhesive film is facilitated.

The adhesive film of the present invention may further contain other components in addition to the aforementioned components.

(E) Curing Accelerator

The curing accelerator (E) may be properly selected depending on the kind of a curable resin or the like prior to use. Examples of the curing accelerator (E) include trisubstituted phosphoniophenolate or a salt thereof, an imidazole compound having a melting point of equal to or more than 150 degrees centigrade and the like. From the viewpoint that the curability of the adhesive film may be effectively improved with the addition of the curing accelerator in a small amount, preferably used is an imidazole compound having a melting point of equal to or more than 150 degrees centigrade. When the melting point of the aforementioned imidazole compound is equal to or more than 150 degrees centigrade, the terminal of the adherend and the terminal of the support can be bonded to each other before completion of curing of the adhesive film. Examples of the imidazole compound having a melting point of equal to or more than 150 degrees centigrade include 2-phenyl-4-methyl-5-hydroxymethylimidazole, 2-phenyl-4-methylimidazole and the like.

The content of the curing accelerator (E) is not particularly limited, but it is preferably from 0.005 to 10% by weight and more preferably from 0.01 to 5% by weight, based on the adhesive film. When the mixing amount of the imidazole compound is equal to or more than the above lower limit, the function as the curing accelerator (E) can be further effectively exhibited and the curability of the adhesive film can be improved. When the mixing amount of imidazole is equal to or less than the above upper limit, the terminal of the adherend and the terminal of the support can be bonded to each other before completion of curing of the adhesive film, and storage stability of the adhesive film can be further improved. These curing accelerators (E) may be used singly or may be used in combination of two or more kinds.

(F) Silane Coupling Agent

The adhesive film may further contain a silane coupling agent (F). With the addition of the silane coupling agent (F), adhesion of the adhesive film to the support or the adherend such as the semiconductor chip, the substrate or the like is increased. Examples of the silane coupling agent (F) include an epoxysilane coupling agent, an aromatic-ring containing aminosilane coupling agent and the like. These may be used singly or may be used in combination of two or more kinds. The mixing amount of the silane coupling agent (F) may be properly selected, but it is preferably from 0.01 to 10% by weight, more preferably from 0.05 to 5% by weight and further preferably from 0.1 to 2% by weight, based on the adhesive film.

(G) Filler

The adhesive film may further contain a filler (G). Thus, the linear expansion coefficient of the adhesive film is lowered and the minimum melt viscosity of the adhesive film is adjusted in the range of 0.01 to 10,000 Pa·s.

Examples of the filler (G) include silver, titanium oxide, silica, mica and the like. However, among these, preferably used is silica. Examples of the shape of the silica filler include crushed silica, spherical silica and the like, and preferably used is spherical silica.

The average particle diameter of the filler (G) is not particularly limited, but it is preferably equal to or more than 0.01 $\mu$m and equal to or less than 20 $\mu$m, and particularly preferably equal to or more than 0.1 $\mu$m and equal to or less than 5 $\mu$m. When it is in the above range, aggregation of the filler (G) in the adhesive film can be suppressed and its appearance can be improved.

The content of the filler (G) is not particularly limited, but it is preferably equal to or more than 0.1% by weight, more preferably equal to or more than 3% by weight, further preferably equal to or more than 5% by weight, and further more preferably equal to or more than 8% by weight, based on the adhesive film. On the other hand, it is preferably equal to or less than 80% by weight, more preferably equal to or less than 60% by weight and further preferably equal to or less than 55% by weight, based on the adhesive film. When the content of the filler is equal to or more than the above lower limit, the difference in linear expansion coefficients between the adhesive film after curing and adherends is reduced, and the stress generated during thermal shock is reduced, so that detachment of adherends can be further surely suppressed. On the other hand, when the content of the filler is equal to or less than the above upper limit, an excessive increase in the elastic modulus of the adhesive film after curing is suppressed, so that the reliability of the semiconductor device is improved. When the content of the filler is in the above range, the minimum melt viscosity of the adhesive film is easily adjusted to 0.01 to 10,000 Pa·s.

The aforementioned respective resin components are mixed to a solvent to give a varnish. The varnish is applied to a base material subjected to peeling of a polyester sheet or the like, and the resulting material is dried at a prescribed temperature until it is substantially free from the solvent, whereby it is possible to obtain an adhesive film. The solvent used herein is not particularly limited as long as it is inert with respect to the components to be used. Suitably used are ketones such as acetone, methyl ethyl ketone, methyl isobutyl ketone, DIBK (diisobutyl ketone), cyclohexanone,

DAA (diacetone alcohol) and the like; aromatic hydrocarbons such as benzene, xylene, toluene and the like; alcohols such as methyl alcohol, ethyl alcohol, isopropyl alcohol, n-butyl alcohol and the like; cellosolves such as methyl cellosolve, ethyl cellosolve, butyl cellosolve, methyl cellosolve acetate, ethyl cellosolve acetate and the like; NMP (N-methyl-2-pyrrolidone), THF (tetrahydrofuran), DMF (dimethylformamide), DBE (dibasic acid ester), EEP (ethyl 3-ethoxypropionate), DMC (dimethyl carbonate) and the like. As the amount of the solvent used, the solid content of the components mixed to the solvent is preferably in the range of 10 to 60% by weight.

The thickness of the obtained adhesive film is not particularly limited, but it is preferably from 1 to 300 μm and particularly preferably from 5 to 200 μm. When the thickness is within the above range, the resin components can be fully filled in the gap between bonding portions and the mechanical adhesion strength after curing of the resin components can be secured.

The thus-obtained adhesive film has a flux activity. Accordingly, the adhesive film may be suitably used in connection of members requiring solder connection such as a semiconductor chip and a substrate, a substrate and a substrate, a semiconductor chip and a semiconductor chip, a semiconductor wafer and a semiconductor wafer, and the like.

Multilayer Circuit Board, Electronic Component, Semiconductor Device

Next, the multilayer circuit board, the electronic component and the semiconductor device using the aforementioned adhesive film will be described.

Fig. 1 is a process cross-sectional view illustrating one example of the method for producing a semiconductor device using the adhesive film of the present invention.
First, as shown in Fig. 1, a semiconductor chip 1 having solder bumps 11 is prepared (Fig. 1(a)).

An adhesive film 2 having the aforementioned flux function is laminated to the semiconductor chip 1 so as to cover the solder bumps 11 of the semiconductor chip 1 (Fig. 1(b)).

As a method of laminating the adhesive film 2 having the flux function to the semiconductor chip 1, there may be used, for example, a roll laminator, a flat-plate press, a wafer laminator and the like. Among these, preferably used is a method of laminating under vacuum (vacuum laminator) so as not to entrain air during lamination.

The laminating conditions are not particularly limited as long as they may enable lamination without voids. However, specifically, the temperature is preferably from 60 to 150 degrees centigrade and the time is preferably from 1 to 120 seconds, while the temperature is particularly preferably from 80 to 120 degrees centigrade and the time is particularly preferably from 5 to 60 seconds. When the laminating conditions are within the above range, the adhesive film is excellent in a balance among adhesion, suppression of extrusion of the resin and the degree of cure of the resin.

The pressurization condition is not particularly limited either, but it is preferably from 0.2 to 2.0 MPa and particularly preferably from 0.5 to 1.5 MPa.

Next, a substrate 3 having a pad portion (not illustrated) on a position corresponding to the solder bumps 11 of the aforementioned semiconductor chip 1 is prepared, and the semiconductor chip 1 and the substrate 3 are temporarily compression-bonded through the adhesive film 2 having a flux function while aligning the semiconductor chip 1 with the substrate 3 (Fig. 1(c)). The temporary compression-bonding conditions are not particularly limited, but the temperature is preferably from 60 to 150 degrees centigrade and the time is preferably from 1 to 120 seconds, while the temperature is particularly preferably from 80 to 120 degrees centigrade and the time is particularly preferably from 5 to 60 seconds. In addition, the pressurization condition is not particularly limited either, but it is preferably from 0.2 to 2.0 MPa and particularly preferably from 0.5 to 1.5 MPa.

Next, the solder bumps 11 are melted to form solder connection portions 111 for bonding the pad and the solders (Fig.1(d)).

The solder connecting condition also varies depending on the kind of the solders in use. For example, in case of Sn-3.5Ag, solders are preferably heated at a temperature of 220 to 260 degrees centigrade for 5 to 500 seconds and particularly preferably at 230 to 240 degrees centigrade for 10 to 100 seconds to carry out solder connection.

This solder bonding is preferably carried out under the conditions such that the solder bumps 11 are melted and solders are bonded to the pad, and then the adhesive film 2 is thermally cured. That is, the solder bonding is preferably carried out under the conditions such that the curing reaction of the adhesive film 2 does not much proceed although the solder bumps 11 are melted. Thus, the solder bumps 11 and the pad can be surely solder-bonded.

Then, the adhesive film 2 is heated and cured. The curing conditions are not particularly limited, but the temperature is preferably from 130 to 220 degrees centigrade and the time is preferably from 30 to 500 minutes, while the temperature is particularly preferably from 150 to 200 degrees centigrade and the time is particularly preferably from 60 to 180 minutes.

In this manner, it is possible to obtain a semiconductor device 10 in which the semiconductor chip 1 and the substrate 3 are attached to each other with a cured product of the adhesive film 2. The semiconductor device 10 is excellent in the electrical connection reliability since the cured product of the adhesive film 2 is used for attachment as

described above. Furthermore, by the use of the adhesive film 2, the solder bumps 11 and the pad are surely solder-bonded and at the same time the gaps due to solder bonding are encapsulated, thus achieving high productivity.

Furthermore, a circuit board and a circuit board are bonded to each other with the cured product of the adhesive film 2 according to the same method, whereby it is possible to obtain a multilayer circuit board.

Also, a semiconductor chip and a semiconductor chip are bonded to each other with the cured product of the adhesive film 2 according to the same method, whereby it is possible to obtain an electronic component.

Hereinafter, the present invention will be described in detail by way of Examples and Comparative Examples. However, the present invention is not restricted to these Examples and Comparative Examples.

## EXAMPLES

### Example 1

Preparation of Varnish for Adhesive Film

55.0 weight parts of a bisphenol F type epoxy resin (EPICLON-830LVP, commercially available from DIC Corporation) as the thermosetting resin (A), 30.8 weight parts of a phenol novolac resin (VR-9305, commercially available from Mitsui Chemicals, Inc.) as the curing agent (B), 3.0 weight parts of sebacic acid (a product of Tokyo Chemical Industry, Co., Ltd.) as the compound having flux activity (C), 10.0 weight parts of a bisphenol F type phenoxy resin (YP-70, commercially available from Tohto Kasei Co., Ltd.) as the film forming resin (D), 0.2 weight parts of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone, whereby a resin varnish having a resin concentration of 50% was prepared.

Preparation of Adhesive Film

The resulting resin varnish was applied on a base material polyester film (Lumira, commercially available from Toray Co., Ltd.) so as to have a thickness of 50 μm, and the resulting material was dried at 100 degrees centigrade for 5 minutes to obtain an adhesive film having a thickness of 25 μm.

Preparation of Semiconductor Device

The resulting adhesive film was laminated to a semiconductor chip (size: 10 mm x 10 mm, thickness: 0.3 mm) having solder bumps (Sn-3.5Ag, melting point: 221 degrees centigrade) at 100 degrees centigrade with a vacuum roll laminator, whereby an adhesive film-attached semiconductor chip was obtained.

Then, while aligning a pad portion of a circuit board having a pad portion with a gold-plated surface and the solder bumps to come into contact with each other, the semiconductor chip was temporarily compression-bonded to the circuit board at 100 degrees centigrade for 30 seconds using a flip chip bonder (a product of Shibuya Kogyo Co., Ltd.).

Next, the resulting material was heated at 235 degrees centigrade for 30 seconds using a flip chip bonder (a product of Shibuya Kogyo Co., Ltd.), whereby solder bumps were melted to carry out solder connection.

Furthermore, the adhesive film was cured by heating at 180 degrees centigrade for 60 minutes, whereby a semiconductor device in which the semiconductor chip and the circuit board were attached with the cured product of the adhesive film was obtained.

### Example 2

Preparation of Varnish for Adhesive Film

An adhesive film and a semiconductor device were prepared in the same manner as in Example 1, except that 50.0 weight parts of a bisphenol A type epoxy resin (EPICLON-840S, commercially available from DIC Corporation) as the thermosetting resin (A), 25.5 weight parts of a phenol novolac resin (VR-9305, commercially available from Mitsui Chemicals, Inc.) as the curing agent (B), 3.0 weight parts of sebacic acid (a product of Tokyo Chemical Industry, Co., Ltd.) as the compound having flux activity (C), 20.0 weight parts of a bisphenol F type phenoxy resin (YP-70, commercially available from Tohto Kasei Co., Ltd.) as the film forming resin (D), 0.5 weight parts of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a resin concentration

of 50%.

Example 3

Preparation of Varnish for Adhesive Film

An adhesive film and a semiconductor device were prepared in the same manner as in Example 1, except that 20.0 weight parts of a cresol novolac type epoxy resin (EOCN-1020-70, commercially available from Nippon Kayaku Co., Ltd.) as the thermosetting resin (A), 15.0 weight parts of a phenol novolac resin (PR55617, commercially available from Sumitomo Bakelite Co., Ltd.) as the curing agent (B), 3.0 weight parts of sebacic acid (a product of Tokyo Chemical Industry, Co., Ltd.) as the compound having flux activity (C), 60.0 weight parts of a bisphenol A type phenoxy resin (YP-50, commercially available from Tohto Kasei Chemical Co., Ltd.) as the film forming resin (D), 1.0 weight part of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a resin concentration of 50%.

Example 4

Preparation of Varnish for Adhesive Film

An adhesive film and a semiconductor device were prepared in the same manner as in Example 1, except that 15.0 weight parts of a cresol novolac type epoxy resin (EOCN-1020-70, commercially available from Nippon Kayaku Co., Ltd.) as the thermosetting resin (A), 8.0 weight parts of a phenol novolac resin (PR55617, commercially available from Sumitomo Bakelite Co. , Ltd.) as the curing agent (B), 6.0 weight parts of phenolphthalin (a product of Tokyo Chemical Industry, Co., Ltd.) as the compound having flux activity (C), 46.0 weight parts of a bisphenol A type phenoxy resin (YP-50, commercially available from Tohto Kasei Co., Ltd.) as the film forming resin (D), 23.0 weight parts of a spherical silica filler (SE6050, commercially available from Admatechs Co., Ltd., average particle diameter: 2 μm) as the filler (G), 1.0 weight part of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a solid content concentration of 40%.

Example 5

Preparation of Varnish for Adhesive Film

An adhesive film and a semiconductor device were prepared in the same manner as in Example 1, except that 13.0 weight parts of a cresol novolac type epoxy resin (EOCN-1020-70, commercially available from Nippon Kayaku Co., Ltd.) as the thermosetting resin (A), 6.0 weight parts of a phenol novolac resin (PR55617, commercially available from Sumitomo Bakelite Co., Ltd.) as the curing agent (B), 5.0 weight parts of phenolphthalin (a product of Tokyo Chemical Industry, Co., Ltd.) as the compound having flux activity (C), 39.0 weight parts of a bisphenol A type phenoxy resin (YP-50, commercially available from Tohto Kasei Co. , Ltd.) as the film forming resin (D), 36.0 weight parts of a spherical silica filler (SE6050, commercially available from Admatechs Co., Ltd., average particle diameter: 2 μm) as the filler (G), 0.5 weight parts of 2-phenyl-4-methylimidazole (2P4MZ, commercially available from Shikoku Chemicals Corp.) as the curing accelerator (E), and 0.5 weight parts of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a solid content concentration of 30%.

Example 6

Preparation of Varnish for Adhesive Film

An adhesive film and a semiconductor device were prepared in the same manner as in Example 1, except that 9.0 weight parts of a cresol novolac type epoxy resin (EOCN-1020-70, commercially available from Nippon Kayaku Co., Ltd.) as the thermosetting resin (A), 4.0 weight parts of a phenol novolac resin (PR55617, commercially available from Sumitomo Bakelite Co. , Ltd.) as the curing agent (B), 4.0 weight parts of phenolphthalin (a product of Tokyo Chemical Industry, Co., Ltd.) as the compound having flux activity (C), 27.0 weight parts of an acrylic acid ester copolymer resin

(SG-P3, commercially available from Nagase ChemteX Corp.) as the film forming resin (D), 55.0 weight parts of a spherical silica filler (SE6050, commercially available from Admatechs Co., Ltd., average particle diameter: 2 μm) as the filler (G), 0.5 weight parts of 2-phenyl-4-methylimidazole (2P4MZ, commercially available from Shikoku Chemicals Corp.) as the curing accelerator (E), and 0.5 weight parts of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a solid content concentration of 20%.

Example 7

Preparation of Varnish for Adhesive Film

An adhesive film and a semiconductor device were prepared in the same manner as in Example 1, except that 55.0 weight parts of a bisphenol F type epoxy resin (EPICLON-830LVP, commercially available from DIC Corporation) as the thermosetting resin (A), 31.8 weight parts of a phenol novolac resin (VR-9305, commercially available from Mitsui Chemicals, Inc.) as the curing agent (B), 2.0 weight parts of sebacic acid (a product of Tokyo Chemical Industry, Co., Ltd.) as the compound having flux activity (C), 10.0 weight parts of a bisphenol F type phenoxy resin (YP-70, commercially available from Tohto Kasei Co., Ltd.) as the film forming resin (D), 0.2 weight parts of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a resin concentration of 50%.

Example 8

Preparation of Varnish for Adhesive Film

An adhesive film and a semiconductor device were prepared in the same manner as in Example 1, except that 15.0 weight parts of a cresol novolac type epoxy resin (EOCN-1020-70, commercially available from Nippon Kayaku Co., Ltd.) as the thermosetting resin (A), 5.0 weight parts of a phenol novolac resin (VR-9305, commercially available from Mitsui Chemicals, Inc.) as the curing agent (B), 60.0 weight parts of sebacic acid (a product of Tokyo Chemical Industry, Co., Ltd.) as the compound having flux activity (C), 18.0 weight parts of a bisphenol A type phenoxy resin (YP-50, commercially available from Tohto Kasei Co., Ltd.) as the film forming resin (D), 1.0 weight part of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a resin concentration of 50%.

Comparative Example 1

Preparation of Varnish for Adhesive Film

An adhesive film and a semiconductor device were prepared in the same manner as in Example 1, except that 59.0 weight parts of a bisphenol F type epoxy resin (EPICLON-830LVP, commercially available from DIC Corporation) as the thermosetting resin (A), 34.9 weight parts of a phenol novolac resin (VR-9305, commercially available from Mitsui Chemicals, Inc.) as the curing agent (B), 3.0 weight parts of sebacic acid (a product of Tokyo Chemical Industry, Co., Ltd.) as the compound having flux activity (C), 2.0 weight parts of a bisphenol F type phenoxy resin (YP-70, commercially available from Tohto Kasei Co., Ltd.) as the film forming resin (D), 0.1 weight part of 2-phenyl-4-methylimidazole (2P4MZ, commercially available from Shikoku Chemicals Corp.) as the curing accelerator (E), and 1.0 weight part of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a resin concentration of 50%.

Comparative Example 2

Preparation of Varnish for Adhesive Film

An adhesive film and a semiconductor device were prepared in the same manner as in Example 1, except that 20.0 weight parts of a cresol novolac type epoxy resin (EOCN-1020-70, commercially available from Nippon Kayaku

Co., Ltd.) as the thermosetting resin (A), 10.0 weight parts of a phenol novolac resin (PR55167, commercially available from Sumitomo Bakelite Co., Ltd.) as the curing agent (B), 8.0 weight parts of phenolphthalin (a product of Tokyo Chemical Industry, Co., Ltd.) as the compound having flux activity (C), 60.0 weight parts of an acrylic acid ester copolymer resin (SG-P3, commercially available from Tohto Kasei Co. , Ltd.) as the film forming resin (D), 1.0 weight part of 2-phenyl-4-methylimidazole (2P4MZ, commercially available from Shikoku Chemicals Corp.) as the curing accelerator (E), 1.0 weight part of β-(3,4-epoxycyclohexyl)ethyltrimethoxysilane (KBM-303, commercially available from Shin-Etsu Chemical Co., Ltd.) as the silane coupling agent (F), and 300.0 weight parts of a spherical silica filler (SE6050, commercially available from Admatechs Co., Ltd., average particle diameter: 2 μm) as the filler (G) were dissolved in methyl ethyl ketone to prepare a resin varnish having a resin concentration of 50%.

Comparative Example 3

Preparation of Varnish for Adhesive Film

An adhesive film and a semiconductor device were prepared in the same manner as in Example 1, except that 42.0 weight parts of a bisphenol F type epoxy resin (EPICLON-830LVP, commercially available from DIC Corporation) as the thermosetting resin (A), 30.0 weight parts of a phenol novolac resin (VR-9305, commercially available from Mitsui Chemicals, Inc.) as the curing agent (B), 3.0 weight parts of sebacic acid (a product of Tokyo Chemical Industry, Co., Ltd.) as the compound having flux activity (C), 15.0 weight parts of an acrylic acid ester copolymer resin (SG-P3, commercially available from Tohto Kasei Co. , Ltd.) as the film forming resin (D), 0.01 weight part of 2-phenyl-4-methylimidazole (2P4MZ, commercially available from Shikoku Chemicals Corp.) as the curing accelerator (E), and 10.0 weight parts of β-(3,4-epoxycyclohexyl)ethyltrimethoxysilane (KBM-303, commercially available from Shin-Etsu Chemical Co., Ltd.) as the silane coupling agent (F) were dissolved in methyl ethyl ketone to prepare a resin varnish having a resin concentration of 50%.

Meanwhile, the adhesive films and the semiconductor devices obtained in the respective Examples and Comparative Examples were evaluated in the following manner. Evaluation items are also shown along with a description of each item. The obtained results are shown in Table 1.

1. Minimum Melt Viscosity of Adhesive Film

The melt viscosities of the resulting adhesive films in the respective Examples and Comparative Examples were measured under the conditions of a parallel plate of 20 mmφ, a gap of 0.05 mm, a frequency of 0.1 Hz and a temperature increase rate of 10 degrees centigrade/min using a viscoelasticity measuring instrument (RheoStress RS150, commercially available from HAKKE Corp.). The lowest melt viscosity was taken as the measured value.

2. 5% weight loss temperature by thermogravimetry (b) - Exothermic Peak Temperature (a) of Adhesive Film

For the exothermic peak temperature (a) of the adhesive films obtained in the respective Examples and Comparative Examples, the curing heat value was measured under the condition of a temperature increase rate of 10 degrees centigrade/min using a differential scanning calorimeter (DSC-6200, commercially available from Seiko Instruments Inc.). The peak temperature (degrees centigrade) was taken as the measured value.

Subsequently, for the 5% weight loss temperature by thermogravimetry (b) of the resulting adhesive films in the respective Examples and Comparative Examples, the weight loss on heating was measured under the condition of a temperature increase rate of 10 degrees centigrade/min using a thermo-gravimetric/differential thermal analyzer (TG/DTA6200, commercially available from Seiko Instruments Inc.). The 5% weight loss temperature (degrees centigrade) was taken as the measured value.

(b) - (a) was calculated from the resulting (a) and (b).

3. Cavities and Voids in Semiconductor Device

With respect to every twenty semiconductor devices obtained in the respective Examples and Comparative Examples, cavities and voids (bubbles) were evaluated by carrying out cross-sectional observation of the solder bumps of the semiconductor chip and the pad portion of the circuit board according to SEM (scanning electron microscope). Respective symbols are as follows.

○: Cavities and voids of equal to or more than 5 μm were not observed.
× : Cavities and voids of equal to or more than 5 μm were observed.

4. Electrical Connectivity of Semiconductor Device

With respect to every twenty semiconductor devices obtained in the respective Examples and Comparative Examples, connection resistance between the semiconductor chip and the circuit board was measured with a digital multimeter respectively at 10 points to evaluate connection reliability. Respective symbols are as follows.

○: Connection resistances of all twenty semiconductor devices (measurement points: 20×10=200) were equal to or less than 3Ω.
Δ: Although all points were electrically connected, connection resistances of 10 to 20 points were equal to or more than 3Ω (practically no problem caused).
×: Connection resistances of equal to or more than 20 points were equal to or more than 3Ω, and open defect was detected at equal to or more than 1 point (practical problem caused).

5. Insulation Reliability of Semiconductor Device

With respect to every twenty semiconductor devices obtained in the respective Examples and Comparative Examples, while applying a voltage of 3V under an environment of a temperature of 130 degrees centigrade and a relative humidity of 85%RH, insulation resistances between adjacent bumps were respectively measured in a continuous manner at 3 points (200 hr) to evaluate ionic migration. Respective symbols are as follows.

○: In all measurement points (20×3=60), dielectric breakdown was not caused.
Δ: Dielectric breakdown was caused in less than 3 points.
× : Dielectric breakdown was caused in equal to or more than 3 points.

[Table 1]

| | | Component | Example 1 | Example 2 | Example 3 | Example 4 | Example 5 | Example 6 |
|---|---|---|---|---|---|---|---|---|
| Mixing | (A) Thermosetting resin | (A-1) | 55.0 | | | | | |
| | | (A-2) | | 50.0 | | | | |
| | | (A-3) | | | 20.0 | 15.0 | 13.0 | 9.0 |
| | (B) Curing agent | (B-1) | 30.8 | 25.5 | | | | |
| | | (B-2) | | | 15.0 | 8.0 | 6.0 | 4.0 |
| | (C) Compound having flux activity | (C-1) | 3.0 | 3.0 | 3.0 | | | |
| | | (C-2) | | | | 6.0 | 5.0 | 4.0 |
| | (D) Film forming agent | (D-1) | 10.0 | 20.0 | | | | |
| | | (D-2) | | | 60.0 | 46.0 | 39.0 | |
| | | (D-3) | | | | | | 27.0 |
| | (E) Curing accelerator | (E-1) | 0.2 | 0.5 | 1.0 | 1.0 | 0.5 | 0.5 |
| | (F) Silane coupling agent | (F-1) | 1.0 | 1.0 | 1.0 | 1.0 | 0.5 | 0.5 |
| | (G) Filler | (G-1) | | | | 23.0 | 36.0 | 55.0 |
| | Total amount of resin composition | | 100.0 | 100.0 | 100.0 | 100.0 | 100.0 | 100.0 |
| | (A)/(C) | | 18.3 | 16.7 | 6.7 | 2.5 | 2.6 | 2.3 |
| Evaluation | Minimum melt viscosity [Pa·s] | | 0.02 | 5 | 60 | 300 | 1800 | 7000 |
| | Exothermic peak temperature (a) [degrees centigrade] | | 218 | 195 | 188 | 194 | 200 | 203 |
| | 5% weight loss temperature by thermogravimetry (b) [degrees centigrade] | | 386 | 394 | 399 | 401 | 401 | 403 |
| | (b)-(a) | | 168 | 199 | 211 | 207 | 201 | 200 |
| | Cavities/Voids | | ○ | ○ | ○ | ○ | ○ | ○ |
| | Electrical connectivity | | ○ | ○ | ○ | ○ | ○ | ○ |
| | Insulation reliability (migration) | | ○ | ○ | ○ | ○ | ○ | ○ |

[Table 1 (continued)]

| | | Component | Example 7 | Example 8 | Comparative Example 1 | Comparative Example 2 | Comparative Example 3 |
|---|---|---|---|---|---|---|---|
| Mixing | (A) Thermosetting resin | (A-1) | 55.0 | | 59.0 | | 42.0 |
| | | (A-2) | | | | | |
| | | (A-3) | | 15.0 | | 20.0 | |
| | (B) Curing agent | (B-1) | 31.8 | 5.0 | 34.9 | | 30.0 |
| | | (B-2) | | | | 10.0 | |
| | (C) Compound having flux activity | (C-1) | 2.0 | 60.0 | 3.0 | | 3.0 |
| | | (C-2) | | | | 8.0 | |
| | (D) Film forming agent | (D-1) | 10.0 | | 2.0 | | |
| | | (D-2) | | 18.0 | | | |
| | | (D-3) | | | | 60.0 | 15.0 |
| | (E) Curing accelerator | (E-1) | 0.2 | 1.0 | 0.1 | 1.0 | 0.01 |
| | (F) Silane coupling agent | (F-1) | 1.0 | 1.0 | 1.0 | 1.0 | 10.0 |
| | (G) Filler | (G-1) | | | | 300.0 | |
| | Total amount of resin composition | | 100.0 | 100.0 | 100.0 | 100.0 | 100.0 |
| | (A)/(C) | | 27.5 | 0.3 | 19.7 | 2.5 | 14.0 |
| Evaluation | Minimum melt viscosity [Pa·s] | | 0.05 | 5 | 0.005 | 14000 | 200 |
| | Exothermic peak temperature (a) [degrees centigrade] | | 216 | 187 | 223 | 209 | 233 |
| | 5% weight loss temperature by thermogravimetry (b) [degrees centigrade] | | 387 | 392 | 379 | 405 | 331 |
| | (b)-(a) | | 171 | 205 | 156 | 196 | 98 |
| | Cavities/Voids | | ○ | ○ | × | ○ | × |
| | Electrical connectivity | | Δ | ○ | ○ | × | ○ |
| | Insulation reliability (migration) | | ○ | Δ | ○ | ○ | ○ |

The respective components in the Table are described below.

(A-1) Bisphenol F type epoxy resin (model number: EPICLON-830LVP, commercially available from DIC Corp.)
(A-2) Bisphenol A type epoxy resin (model number: EPICLON-840S, commercially available from DIC Corp.)
(A-3) Cresol novolac type epoxy resin (model number: EOCN-1020-70, commercially available from Nippon Kayaku Co., Ltd.)
(B-1) Phenol novolac resin (model number: VR-9305, commercially available from Mitsui Chemicals, Inc.)
(B-2) Phenol novolac resin (model number: PR55617, commercially available from Sumitomo Bakelite Co., Ltd.)
(C-1) Sebacic acid (a product of Tokyo Chemical Industry, Co., Ltd.)
(C-2) Phenolphthalin (a product of Tokyo Chemical Industry, Co., Ltd.)
(D-1) Bisphenol F type phenoxy resin (model number: YP-70, commercially available from Tohto Kasei Co., Ltd.)
(D-2) Bisphenol A type phenoxy resin (model number: YP-50, commercially available from Tohto Kasei Co., Ltd.)
(D-3) Acrylic acid ester copolymer resin (model number: SG-P3, commercially available from Nagase ChemteX Corp.)
(E-1) 2-phenyl-4-methylimidazole (model number: 2P4MZ, commercially available from Shikoku Chemicals Corp.)
(F-1) β-(3,4-epoxycyclohexyl)ethyltrimethoxysilane (model number: KBM-303, commercially available from Shin-Etsu Chemical Co., Ltd.)
(G-1) Spherical silica filler (model number: SE6050, commercially available from Admatechs Co., Ltd., average particle diameter: 2 μm)

For the adhesive film obtained in Example 1, the minimum melt viscosity was 0.02 Pa·s, and the difference between the 5% weight loss temperature by thermogravimetry (b) and the exothermic peak temperature (a) was 168 degrees centigrade. The semiconductor device was prepared with the adhesive film obtained in Example 1 and evaluated, and as a result, all of cavities, voids, electrical connectivity and insulation reliability were excellent as shown in Table 1.

Furthermore, the adhesive films and the semiconductor devices obtained in the respective Examples 2 to 8 exhibited almost the same behavior as those of Example 1.

This application is based on Japanese patent application No. 2009-214528 filed on September 16, 2009, the content of which is incorporated hereinto by reference.

## Claims

1. An adhesive film electrically connecting a first terminal of a support and a second terminal of an adherend using solders, and attaching the support to the adherend, wherein the adhesive film comprises a thermosetting resin (A), a curing agent (B), a compound having flux activity (C) and a film forming resin (D), the minimum melt viscosity of the adhesive film is from 0.01 to 10, 000 Pa·s, and the adhesive film satisfies the following formula (1) when the exothermic peak temperature (degrees centigrade) of the adhesive film is defined as (a) and the 5% weight loss temperature by thermogravimetry (degrees centigrade) of the adhesive film is defined as (b),

$$(b)-(a) \geq 100 \text{ degrees centigrade} \qquad (1).$$

2. The adhesive film according to claim 1, wherein the mixing ratio ((A)/(C)) of the thermosetting resin (A) to the compound having flux activity (C) is from 0.5 to 20.

3. The adhesive film according to claim 1 or 2, wherein the content of the thermosetting resin (A) is from 5 to 80% by weight, based on said adhesive film.

4. The adhesive film according to any one of claims 1 to 3, wherein the thermosetting resin (A) is an epoxy resin.

5. The adhesive film according to any one of claims 1 to 4, wherein the compound having flux activity (C) is a flux activating compound having a carboxyl group and/or a phenolic hydroxyl group.

6. The adhesive film according to any one of claims 1 to 4, wherein the compound having flux activity (C) is a flux activating compound containing, in one molecule thereof, two phenolic hydroxyl groups and at least one carboxyl group which is directly bonded to an aromatic ring.

7. The adhesive film according to any one of claims 1 to 6, wherein the compound having flux activity (C) contains a compound represented by the following general formula (2),

$$HOOC-(CH_2)_n-COOH \qquad (2)$$

wherein, in the general formula (2), n is an integer of 1 to 20.

8. The adhesive film according to any one of claims 1 to 6, wherein the compound having flux activity (C) contains a compound represented by the following general formula (3) and/or (4),

[Chemical Formula (5)]

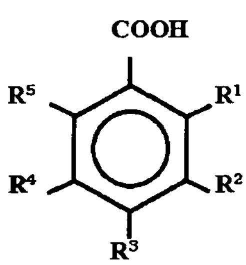

(3)

wherein, in the general formula (3), $R^1$ to $R^5$ are each independently a monovalent organic group, and at least one of $R^1$ to $R^5$ is a hydroxyl group,

[Chemical Formula (6)]

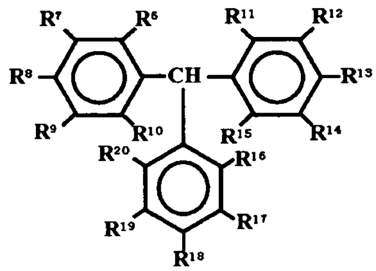

(4)

wherein, in the general formula (4), $R^6$ to $R^{20}$ are each independently a monovalent organic group, and at least one of $R^6$ to $R^{20}$ is a hydroxyl group or a carboxyl group.

**9.** The adhesive film according to any one of claims 1 to 8, wherein said adhesive film further contains a filler (G) .

**10.** The adhesive film according to claim 9, wherein the content of the filler (G) is equal to or more than 0.1% by weight and equal to or less than 80% by weight, based on said adhesive film.

**11.** The adhesive film according to any one of claims 1 to 10, wherein said adhesive film further contains a silane coupling agent (F) in an amount of equal to or more than 0.01% by weight and equal to or less than 5% by weight, based on said adhesive film.

**12.** A multilayer circuit board, comprising a cured product of the adhesive film according to any one of claims 1 to 11.

**13.** An electronic component, comprising a cured product of the adhesive film according to any one of claims 1 to 11.

**14.** A semiconductor device, comprising a cured product of the adhesive film according to any one of claims 1 to 11.

FIG.1

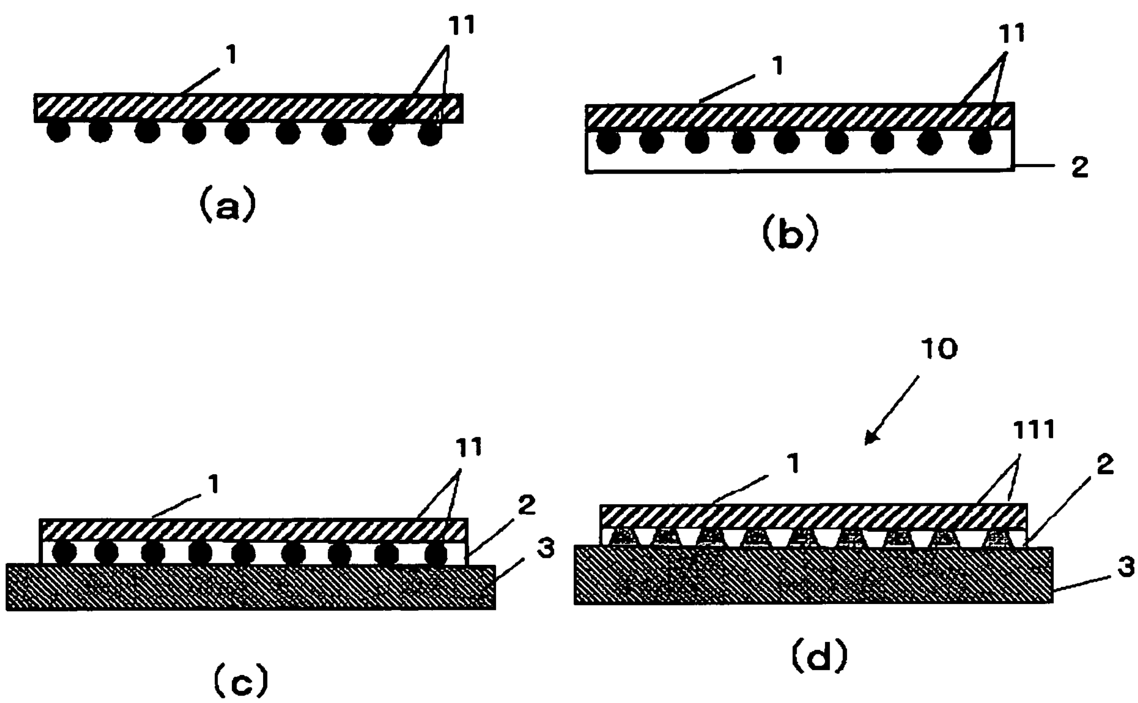

## INTERNATIONAL SEARCH REPORT

International application No.
PCT/JP2010/005510

A. CLASSIFICATION OF SUBJECT MATTER
*C09J7/00*(2006.01)i, *C09J11/06*(2006.01)i, *C09J163/00*(2006.01)i, *C09J201/10*(2006.01)i, *H01L21/60*(2006.01)i, *H05K3/34*(2006.01)i

According to International Patent Classification (IPC) or to both national classification and IPC

B. FIELDS SEARCHED

Minimum documentation searched (classification system followed by classification symbols)
C09J1/00-201/10, H01L21/60, H05K3/34

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2008/054012 A1 (Sumitomo Bakelite Co., Ltd.), 08 May 2008 (08.05.2008), claims; page 31, line 21 to page 34, line 7 & US 2010/0078830 A1 & EP 2096671 A1 & CA 2667853 A & KR 10-2009-0076928 A & CN 101536185 A | 1-14 |
| A | JP 2004-273809 A (Sumitomo Bakelite Co., Ltd.), 30 September 2004 (30.09.2004), claims; paragraphs [0023], [0027], [0030], [0039] to [0043], [0051] (Family: none) | 1-14 |

☒ Further documents are listed in the continuation of Box C.    ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 December, 2010 (03.12.10) | 21 December, 2010 (21.12.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/005510

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-307169 A (Hitachi Chemical Co., Ltd.), 04 November 2005 (04.11.2005), claims; paragraphs [0010], [0040], [0041] (Family: none) | 1-14 |
| A | JP 2005-519169 A (National Starch and Chemical Investment Holding Corp.), 30 June 2005 (30.06.2005), claims; paragraphs [0022], [0030] to [0048] & US 2003/0164555 A1 & US 2006/0125119 A1 & EP 1481420 A1 & WO 2003/075339 A1 & CN 1639852 A | 1-14 |
| A | US 7247683 B2 (J.M.Hurley et al.), 24 July 2007 (24.07.2007), claims; column 11, line 10 to column 13, line 54 (Family: none) | 1-14 |
| A | JP 2004-75788 A (Nitto Denko Corp.), 11 March 2004 (11.03.2004), claims; paragraphs [0065] to [0069] (Family: none) | 1-14 |
| A | JP 2008-144161 A (Hitachi Chemical Co., Ltd.), 26 June 2008 (26.06.2008), claims; paragraphs [0071] to [0073], [0080], [0119] (Family: none) | 1-14 |

Form PCT/ISA/210 (continuation of second sheet) (July 2009)

**INTERNATIONAL SEARCH REPORT**

International application No.
PCT/JP2010/005510

Claim 1 includes all of the adhesive films each comprising (A) a heat-curable resin, (B) a curing agent, (C) a flux-active compound and (D) a film-forming resin, each of which has a desired property "an adhesive film characterized by having a lowest melt viscosity of 0.01 to 10,000 Pa·s and meeting the requirement represented by formula (1): (b)-(a) ≥ 100°C wherein (a) represents an exothermic peak temperature (°C) of the adhesive film and (b) represents a 5% weight heating loss temperature (°C) of the adhesive film". However, those adhesive films which are disclosed in the meaning within PCT Article 5 are only adhesive films which are disclosed in the description and each of which contains a specific epoxy resin as the (A) heat-curable resin and a specific phenol novolac resin as the (B) curing agent. Therefore, claim 1 is not supported in the meaning within PCT Article 6.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S61276873 B
- JP H0931419 B
- JP 2009214528 A